(19) Europäisches Patentamt / European Patent Office / Office européen des brevets

(11) **EP 3 472 384 B1**

(12) **EUROPEAN PATENT SPECIFICATION**

(45) Date of publication and mention
of the grant of the patent:
**07.06.2023 Bulletin 2023/23**

(21) Application number: **17814819.3**

(22) Date of filing: **19.06.2017**

(51) International Patent Classification (IPC):
*G01N 24/08* (2006.01)   *D21D 1/00* (2006.01)
*D21F 1/00* (2006.01)   *D21G 9/00* (2006.01)
*G01R 33/44* (2006.01)   *G01N 1/20* (2006.01)
*G01R 33/30* (2006.01)

(52) Cooperative Patent Classification (CPC):
**D21F 1/0009; D21G 9/0018; G01N 24/085;**
**G01R 33/448;** G01N 1/2035; G01R 33/307

(86) International application number:
**PCT/FI2017/050457**

(87) International publication number:
**WO 2017/220859 (28.12.2017 Gazette 2017/52)**

(54) **METHOD, DEVICE AND SYSTEM FOR DETERMINING THE BEATING RATE OF A FIBRE SUSPENSION**

VERFAHREN, VORRICHTUNG UND SYSTEM ZUR BESTIMMUNG DER SCHLAGZAHL EINER FASERSUSPENSION

PROCÉDÉ, DISPOSITIF ET SYSTÈME POUR LA DÉTERMINATION DE LA FRÉQUENCE DE BATTEMENT D'UNE SUSPENSION DE FIBRES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.06.2016 FI 20165509**

(43) Date of publication of application:
**24.04.2019 Bulletin 2019/17**

(73) Proprietor: **Kaakkois-Suomen
Ammattikorkeakoulu Oy
50100 Mikkeli (FI)**

(72) Inventors:
• **HILTUNEN, Yrjö**
**FI-57200 Savonlinna (FI)**
• **KÄYHKÖ, Jari**
**FI-57200 Savonlinna (FI)**
• **TIRRI, Tapio**
**FI-57200 Savonlinna (FI)**

(74) Representative: **Kespat Oy
Vasarakatu 1
40320 Jyväskylä (FI)**

(56) References cited:
**JP-A- 2005 077 135   US-A- 5 302 896**

• **HELENA LENNHOLM ET AL: "The effects of laboratory beating on cellulose structure", NORDIC PULP AND PAPER RESEARCH JOURNAL, vol. 10, no. 2, 1 May 1995 (1995-05-01), pages 104-109, XP055666540, SE ISSN: 0283-2631, DOI: 10.3183/npprj-1995-10-02-p104-109**
• **TIE QIANG LI ET AL: "Water-cellulose interaction in wood pulp fiber suspensions studied by oxygen-17 and deuterium NMR relaxation. The effect of beating", LANGMUIR, vol. 8, no. 2, 1 February 1992 (1992-02-01), pages 680-686, XP055445321, US ISSN: 0743-7463, DOI: 10.1021/la00038a063**
• **MATS HAGGKVIST ET AL: "Effects of drying and pressing on the pore structure in the cellulose fibre wall studied by 1H and 2H NMR relaxation", CELLULOSE, vol. 5, no. 1, 1 January 1998 (1998-01-01), pages 33-49, XP055666536, Netherlands ISSN: 0969-0239, DOI: 10.1023/A:1009212628778**

- **SUNKYU PARK ET AL: "Hard to remove water in cellulose fibers characterized by high resolution thermogravimetric analysis - methods development", CELLULOSE, KLUWER ACADEMIC PUBLISHERS (DORDRECHT), NL, vol. 13, no. 1, 1 February 2006 (2006-02-01), pages 23-30, XP019234599, ISSN: 1572-882X, DOI: 10.1007/S10570-005-9009-0**
- **STEVEN B. THOMA ET AL: "On-line Surface Area Measurement of Concentrated Slurries using low field spin-lattice relaxation NMR", PARTICLE AND PARTICLE SYSTEMS CHARACTERIZATION., vol. 10, no. 5, 1 November 1993 (1993-11-01), pages 246-251, XP055671497, DE ISSN: 0934-0866, DOI: 10.1002/ppsc.19930100506**

## Description

The invention is related to a method for determining the beating rate of a fibre suspension, wherein

- part of a fibre suspension flow is led to a separate flow channel as a sample,
- the beating rate is determined based on the sample.

The invention is also related to a corresponding device and system.

In the manufacturing of paper and board products, an essential status parameter of the fibre material is its beating rate, which is controlled mainly during beating. The beating rate of pulp has a strong effect on the properties of the end product; for example, it is possible to increase the tensile strength of a product by increasing beating. On the other hand, the beating of pulp consumes energy and impairs dewatering, thus reducing the highest possible production speed of the paper machine and decreasing production.

In prior art, the beating rate has been traditionally determined with laboratory measurements; that is, a sample has been taken from the fibre suspension flow arriving from the beater to deliver to the laboratory. In the laboratory, the drainability of the sample and an index representing the beating rate, such as the Schopper-Riegler number (henceforth, SR number) or Canadian Standard Freeness (henceforth, CSF number) are determined. However, the determination of the beating rate in the laboratory is a slow and laborious operation, which provides information about the beating rate of a fibre suspension afterwards, related exclusively to a momentary condition at the time of measuring. In other words, the measurement result is only obtained notably later, after the fibre suspension, from which the sample was taken, may have passed through the fibre web machine many hours earlier.

Prior art equipment marketed by the trade name Valmet Pulp Expert performs laboratory measurements, which were previously carried out manually, automatically by automating handsheet testing. However, the equipment is very expensive and does not remove the problem related to that the measurement is still carried out slowly in the fibre suspension, which may already have passed through the fibre web machine. The determination of the beating rate may take even hours with this equipment.

Publication US 5,302,896 A discloses a pulsed NMR system for industrial measurements comprising sample throughout system and user system controls to establish digitized free induction decay curves, from which Abragam, Gaussian and exponential components are determined using a Marquardt-Levenberg iteration technique, and using regression techniques to correlate the curve components to the target nuclei.

Publication JP 2005 077135 A discloses a method for determining a beating rate of a fibre suspension by means of an online ultrasound measurement of a part of the fibre suspension flow led to a separate flow channel, by means of an ultrasonic oscillator and receiver.

HELENA LENNHOLM ET AL: "The effects of laboratory beating on cellulose structure", NORDIC PULP AND PAPER RESEARCH JOURNAL, vol. 10, no. 2, 1 May 1995 (1995-05-01), pages 104-109, SE ISSN: 0283-2631, DOI: 10.3183/npprj-1995-10-02-p104-109 discloses an experimental study of effects of laboratory beating on cellulose structure as studied with 13C-CP/MAS-NMR-spectroscopy.

TIE QIANG LI ET AL: "Water-cellulose interaction in wood pulp fiber suspensions studied by oxygen-17 and deuterium NMR relaxation. The effect of beating", LANGMUIR, vol. 8, no. 2, 1 February 1992 (1992-02-01), pages 680-686, US ISSN: 0743-7463, DOI: 10.1021/la00038a063 discloses an experimental study of 17O and 2H NMR relaxation rates measured for water in suspensions of two types of wood pulp cellulose fibers as functions of fiber concentration, temperature, and resonance frequency, wherein the fibers have been subjected to various degrees of mechanical treatment (beating).

MATS HAGGKVIST ET AL: "Effects of drying and pressing on the pore structure in the cellulose fibre wall studied by 1H and 2H NMR relaxation", CELLULOSE, vol. 5, no. 1, 1 January 1998 (1998-01-01), pages 33-49, Netherlands ISSN: 0969-0239, DOI: 10.1023/A:1009212628778 discloses a 1H and 2H NMR relaxation method used to investigate the influence of drying and pressing on the pore size ; and pore size distribution in the cellulose fibre wall.

The object of the invention is to provide a method that is simpler and faster than prior art methods for determining the beating rate of a fibre suspension, with which the beating rate can be determined almost in real time as an online measurement. The characteristic features of this invention are set forth in the appended claim 1. Another object of the invention is to provide a device that is simpler and faster than prior art devices for determining the beating rate of a fibre suspension, with which the beating rate can be determined almost in real time as an online measurement. The characteristic features of this invention are set forth in the appended claim 5.

This object is achieved with a method for determining the beating rate of a fibre suspension according to the appended claims, wherein the beating rate is determined as an online measurement based on a sample using a time domain NMR spectroscope and an empirically defined correlation function in the following steps, in which part of a fibre suspension flow is led to a separate flow channel as a sample and a magnetic field is generated in the flow channel, protons contained in water in the fibre suspension are excited by means of a frequency pulse provided by a coil, and the response signal of the frequency pulse returning to the coil from protons is measured. In the method, the beating rate of a fibre suspension is determined based on a response signal. Due to its nature, the use of a time domain NMR spectroscopy is fast and reliable and can therefore be performed as an online measurement in connection with a beater. In turn, this enables immediate adjustments in the use of the beater based on the determination of the beating rate. With the use of time domain NMR spectroscope, it is possible to quickly determine the response signal returning from protons, which correlates with the ratio of water bound to free water in the fibre suspension. A time domain NMR spectroscope is notably simpler in design compared to, for example, the other NMR spectroscopes, since the time domain NMR spectroscope can be implemented without tools required for homogenisation of the magnetic field.

In the method according to the invention, it is surprising that the beating rate can be determined with time domain NMR spectroscope in a sample with a high water content, since the beating rate is determined based on the ratio of water bound to free water in the fibre suspension, which is determined based on the attenuation of the response signal. Generally, prior art NMR spectroscopic techniques have been based on the determination of an element, such as carbon or other similar content, where water contained in the fibre suspension has been a factor that disturbs the measurement.

Advantageously, a relatively non-homogeneous magnetic field is used in the method compared to the homogeneous magnetic field used in prior art NMR spectroscopy, without determination of position data. In other words, the time domain NMR spectroscope has been implemented without tools for generating a variable magnetic field, which also allows realisation of the measurement, for example, without a Fourier transform requiring high computational power, using only determination of T2 relaxation time.

In this way, the calculation can be very simple and quick enabling an almost real-time determination of the beating rate.

According to an embodiment, the sample is led back to the fibre suspension flow. In this case, the beating rate can be determined without fibre suspension losses.

Advantageously, the method according to the invention uses a permanent magnet for generating a magnetic field. With the use of a permanent magnet, a magnetic field is automatically generated without separate control or adjustment, which are necessary in variable magnetic fields.

Advantageously, the response signal is measured as an amplitude of voltage generated by the coil. Measuring the amplitude is simple and reliable.

Advantageously, the method measures an average amplitude. An average amplitude is easy to determine in a signal in relation to the entire spectrum, and position data is not needed in determining the beating rate, as is the case in general NMR spectroscopic techniques.

According to an embodiment, protons contained in water in the fibre suspension are excited by several frequency pulses and the beating rate is determined based on the relaxation time measured in the response signal. The relaxation time can be determined from an exponentially decreasing function using attenuating response signals generated by the various frequency pulses. The function returns the attenuation factor of the response signal, which gives the relaxation time.

According to another embodiment, the beating rate is determined by measuring the response signal for the so-called FID (Free Induction Decay) signal, which allows determination of the beating rate of a fibre suspension based on an individual response signal.

Advantageously, the correlation function is defined before the actual beating rate determination in steps, wherein a response signal is determined for several fibre suspensions with known beating rates and a correlation function is formed between the return signals and beating rates. By comparing the measured response signals with the response signals of fibre suspensions with known beating rates, the beating rate of the sample can be reliably determined.

According to an embodiment, the correlation function has a form $Sr = A * T2(NMR) + B$, where $Sr$ is the Schopper-Riegler number, $A$ and $B$ are empirically defined constants and $T2$ is the relaxation time. Thus, it is possible to skip the step of comparison between empirically defined ratios and the ratio obtained from the measurement, which accelerates the determination of the beating rate. The same form of the correlation function is suitable for use when using other indices representing the beating rate, such as the CSF number.

With the correlation function, it is possible to determine the beating rate of a fibre suspension contained in a sample. The correlation function corresponds to the comparison of the number representing the ratio of bound water to free water with an empirically created database, which contains ratios of bound water to free water with different beating rates.

In this context, a simplified term 'NMR device' can also be used for an NMR spectroscope. More specifically, a time domain spectroscope is a spectroscope that measures the intensity of electromagnetic radiation as a function of time, not as a function of frequency or wavelength.

Advantageously, the T2 relaxation time is calculated in the method. The T2 relaxation time is faster to calculate than the T1 relaxation time and is thus more suitable for an online measurement.

To determine the T2 relaxation time, it is possible to use the CPMG (Carr-Parcell-Meiboom-Gill) pulse sequence. The CPMG pulse sequence is a generally used, proven and approved pulse sequence.

According to an embodiment, a sample is taken from a fibre suspension flow arriving from a beater. Thus, the beating rate of the fibre suspension exiting the beater can be determined and this information can be used to adjust the beater.

According to another embodiment, a sample is taken from both the inlet and outlet fibre suspension flows of a beater. Thus, it is possible to determine the effect of the beater on the beating rate even more precisely and thereby also adjust the operation of the beater.

In the method, a sample can be taken continuously at intervals of 0.5 - 2.5 minutes. Thus, the variation of the beating rate produced by the beater can be monitored and adjusted continuously and almost in real time.

Advantageously, the sample is stopped in the device for the duration of the frequency pulse generation and signal measurement. In this way, it can be ensured that the same sample is exposed to all of the frequency pulses of the pulse sequence and the measuring equipment can measure the voltage induced to the coil exactly by the energy delivered by these. To stop the sample, it is possible to use the valves located on both sides of the device.

The object of the device according to the invention is achieved with a device for determining the beating rate of a fibre suspension, the device including equipment for determining the beating rate based on a sample, comprising a flow channel, a computer and software means and connection means for connecting the equipment to a side flow channel arranged in the vicinity of the beater, the side flow channel being arranged to lead part of the fibre suspension flow arriving from the beater to form a separate sample. The device is arranged to be connected in the vicinity of the beater for determining the beating rate as an online measurement and the equipment for determining the beating rate is a time domain NMR spectroscope, including at least one coil arranged around the flow channel to excite protons contained in water in the fibre suspension of the sample by means of frequency pulses, a magnet arranged around the flow channel for generating a magnetic field in the flow channel and a power source with controllers connected to the coil for generating frequency pulses. In addition, the NMR spectroscope includes measuring equipment for measuring the intensity of voltage generated by the frequency pulse returning to the coil from protons for generating a response signal, and said computer equipped with said software means for determining the beating rate of samples based on the response signal.

With the device according to the invention, it is possible to quickly determine spin-spin relaxation time T2(NMR) of protons as an online measurement utilising time domain NMR spectroscopy and use the measured T2 (NMR) for determining the beating rate of the fibre suspension in the sample. A time domain NMR spectroscope has a relatively simple design, since it can be implemented without tools for generating a variable magnetic field, enabling also simpler calculation of relaxation times without Fourier transforms.

The magnet used is advantageously a permanent magnet. A permanent magnet can be implemented without electric power supply, which makes it more affordable in terms of investment and use.

Advantageously, said magnet and coil are overlapping in the radial direction relative to the flow channel in such a way that the flow channel is surrounded by the coil and the coil is surrounded by the magnet. In this way, the magnetic field generated by the magnet also extends to the area of influence of the coil.

Advantageously, the device includes a box construction for encasing the magnet and coil to generate a closed magnetic field. With the encasing, it is possible to prevent the expansion of the magnetic field to the environment so that any metal present in the environment will not disturb the measurement nor will the device disturb surrounding equipment.

Advantageously, the computer is arranged to control the power source for generating frequency pulses by means of the coil. With the computer, the operation of the coil can be controlled delivering frequency pulses exclusively when a sample is present in the magnetic field. In this way, it is possible to make savings in the power consumption of the device.

According to the invention, software means are arranged to determine the beating rate of a fibre suspension using relaxation times and an empirical correlation function based on the ratio of water bound to free water in the fibre suspension. Thus, the device can be relatively simple and quickly operating and thereby suitable for online measurements.

In this context, the power source controllers are advantageously a computer and related control electronics for pulsing the power source to generate frequency pulses.

Advantageously, the device also includes a sample unit, which includes said coil and two capacitors arranged within a magnet. The sample unit is a resonance circuit, the resonance frequency of which can be adjusted with a capacitor. The resonance frequency must be the same frequency that is delivered by protons from the sample.

The object of the system according to the invention can be achieved with a system for determining the beating rate of a fibre suspension, the system including a side flow channel arranged to be fastened in the vicinity of a beater, arranged to lead part of the fibre suspension flow arriving from the beater to form a separate sample, and a device according to one of the embodiments of the invention proposed above combined with said side flow channel for determining the beating rate of a fibre suspension from the fibre suspension flow in the side flow channel. The system according to the invention can be implemented in context with new beaters or it can also be located in context with existing beaters by forming a separate sampling line in the vicinity of the beater.

Advantageously, the system includes a first valve arranged in the flow channel prior to the equipment and a second valve arranged in the flow channel after the equipment for stopping the sample for the duration of the measurement performed by the equipment. With the valves, the flow can be stopped in the channel for the duration of the measurement.

Advantageously, the first valve and the second valve are solenoid valves. The operation of solenoid valves is easy to control electrically and they are highly resistant to external disturbances.

Advantageously, the system includes a pump arranged in the flow channel for aspirating the sample to the equipment. With the pump, it is possible to ensure that the sample is conveyed up to the equipment, even if the solids content of the fibre suspension would be high.

The pump can be a hose pump. Such a pump is very reliable for pumping a fibre suspension with a high solids content.

Advantageously, the system includes a relay for controlling the power supply to both the first and the second valve and the pump, to control their operation. In this way, sampling can be easily managed by controlling a single relay.

According to an embodiment, the side flow channel forms the flow channel of the NMR spectroscope.

The invention is described below in detail by making reference to the appended drawings that illustrate some of the embodiments of the invention, in which:

Figure 1a    depicts the process position according to a first embodiment of the system according to the invention,

Figure 1b    depicts the process position according to a second embodiment of the system according to the invention,

Figure 2    is a basic view of a system according to the invention,

Figure 3    is a cross-sectional view of a device according to the invention,

Figure 4    is a block diagram of steps of a method according to the invention,

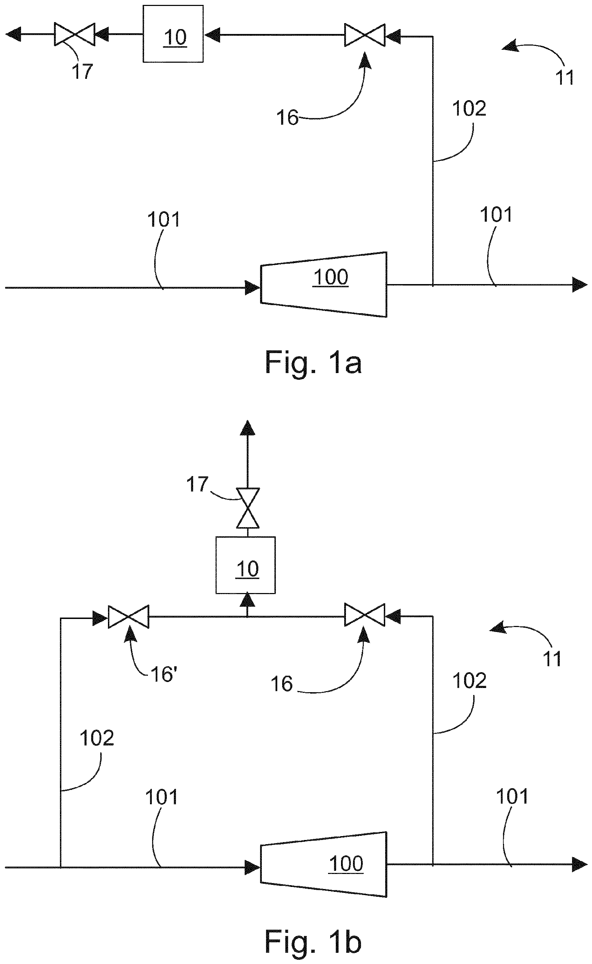

As shown in Figures 1a and 1b, a device 10 according to the invention is arranged to be used in context with a beater 100 in a system 11 according to the invention. As shown in Figure 1a, the device 10 can be located in such a way that a small side flow is deviated from the fibre suspension flow 101 led to the beater 100 into a side flow channel 102, which is positioned, as shown in Figure 1a, after the beater 100 and which leads part of the fibre suspension flow to the device 10 according to the invention. The device 10 is advantageously connected to the side flow channel 102, which can be an existing flow channel associated with the beater or a part of a system according to the invention installed for this purpose.

The side flow channel 102 advantageously has a first valve 16 for sampling, with which it is possible to adjust the volume and flow rate of the fibre suspension led to the device 10, and a second valve 17, with which the sample can be stopped in the device 10 for the duration of the measurement. According to Figure 1b, a fibre suspension flow can also be led to the device 10 via two side flow channels 102. One side flow channel 102 is advantageously a flow channel, which is used to lead the fibre suspension flow before the beater 100 through the one first valve 16 to the device 10. The other side flow channel is advantageously a flow channel, which is used to lead the fibre suspension flow after the beater 100 through the other first valve 16 to the device 10. In this way, it is possible to perform comparative measurements for both the inlet fibre suspension and the outlet fibre suspension, already beaten. The size of the sample led from the fibre suspension to the device can be as small as 1 - 10 cm$^3$, in which case the equipment is also relatively smallscale. However, such a sample is sufficient for determining the beating rate.

As shown in Figures 1a - 3, the system 11 according to the invention for determining the beating rate of a fibre suspension includes a side flow channel 102 and a device 10 according to the invention. In other words, in the system according to the invention, part of the fibre suspension flow is led to a side route for an online measurement, wherein the measurement is performed using the device 10 according to the invention. The first valve 16 is used to control the taking of a sample from the fibre suspension flow 14. Arranged in the vicinity of the side flow channel 102, there is a device 10 according to the invention comprising connection units 13 and equipment 18 for determining the beating rate based on the sample, the equipment 18 being a time domain NMR spectroscope 20. The connection units 13 are connections, with which the flow channel 12 of the NMR spectroscope 20 is connected to the side flow channel 102 so that the flow channel 12 and the side flow channel 102 form a continuous route for the fibre suspension through the NMR spectroscope 20.

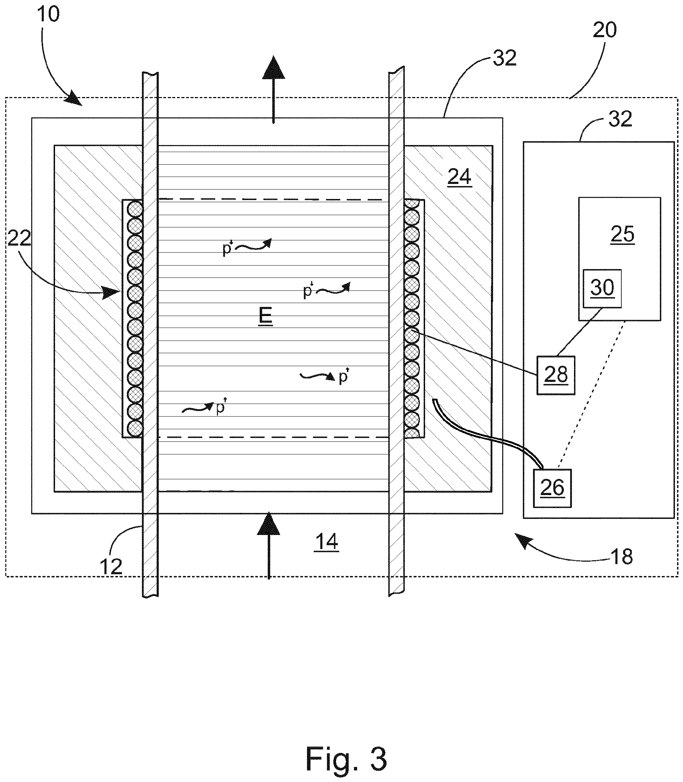

More specifically, the NMR spectroscope 20 of the device 10 according to the invention includes a flow channel 12, at least one coil 22 for exciting protons p contained in free and bound water of fibres in the fibre suspension flow, arranged around the flow channel 12 as shown in Figure 3. The NMR spectroscope 20 also includes a magnet 24 arranged around the flow channel 12 for generating a magnetic field E in the flow channel 12. Advantageously, the magnet 24 is also arranged around the coil 22 in the radial direction relative to the flow channel 12 on top of the coil 22. The magnetic field E generated by the magnet 24 is advantageously a magnetic field as homogeneous and static as possible, through which the fibre suspension flow 14 passes inside the flow channel 12. The magnetic field E is depicted in the figure with lines in the transverse direction relative to the flow channel. The direction of the magnetic field is advantageously transversal relative to the longitudinal direction of the flow channel. The magnet is advantageously a permanent magnet, which can be implemented without a separate drive power for operation. A permanent magnet generates a static permanent magnetic field in itself. Alternatively, the magnet can also be an electromagnet, the magnetic field of which is provided by electric current.

In addition, the NMR spectroscope 20 includes, as shown in Figure 3, a power source 26 connected to a coil 22 for generating frequency pulses, measuring equipment 28 for measuring the intensity of voltage generated by the frequency pulse returning to the coil 22 from protons p for generating a response signal, and software means 30 for determining the beating rate of samples based on the response signal and for controlling a valve 16 for taking samples. With the power source 26, a frequency pulse is delivered to the coil 22 to excite protons p contained in bound and free water travelling inside the coil 22 into a higher energy state (spin), with the protons absorbing the frequency pulse. This energy state discharges rapidly (in milliseconds), whereat the proton p delivers or emits energy to its surrounding, which again generates a voltage, i.e. a response signal, in the coil 22, the amplitude of the signal being measurable with the measuring equipment 28. Based on the measured response signal, software means 30 can advantageously define, using the correlation function applied, the response signal of exactly the correct beating rate of a fibre suspension that this response signal corresponds to and thereby determine the beating rate of the fibre suspension taken as the sample.

Advantageously, the magnet 24, the coil 22 and the flow channel 12 are encased using a box construction 32 according to Figure 3. Advantageously, the box construction is made of metal, thus preventing expansion of the magnetic field to the environment and, on the other hand, access of disturbances external to the device to the magnetic field. In this way, the device according to the invention can easily provide a closed magnetic field and is thus easily applicable in mill conditions. Basically, the aforementioned components of the NMR spectroscope 20 can be placed within the same box construction; however, there are preferably two box constructions. One box construction includes measuring equipment 28, a computer 25 and a power source 26, whereas the other box construction encloses a magnet 24 and a coil 22. In this way, damage to sensitive electronic components is avoided in case of leaks of a water-containing fibre suspension.

The relaxation time correlates with the ratio of free water and bound water contained in fibres in the fibre suspension, which ratio will change during beating as fines detach on the surface of fibres and fibres fibrillate. Beating changes the relaxation time so that the relaxation time T2 shortens as the beating rate increases. The so-called CPMG (Carr-Parcell-Meiboom-Gill) pulse sequence, which contains one 90° pulse and several 180° pulses, can be used to determine the spin-spin relaxation time T2. Amplitudes of echoes of the pulse sequence attenuate according to the following equation:

$$a(t) = a_o \exp(-t/T2),$$

where $a_0$ is the amplitude at the time t = 0s and T2 = spin-spin relaxation time. Parameters $a_o$ and T2 can be defined by placing the equation in an experimental signal.

The diameter of the flow channel can be at least 10 mm, preferably 10 - 20 mm, to allow for the fibre suspension to flow in the flow channel without problems. The dry solids content of the fibre suspension may generally range between 0.5% and 4.0% by weight, at which it remains pumpable. Fibre suspensions at a higher dry content may require a higher pressure to move in the flow channel, but when placed after the beater, the sample is taken from the fibre suspension flow where the pressure is generally sufficient. Advantageously, a separate pump is also used in the side flow channel for moving the fibre suspension forward. The small flow channel diameter proposed above also enables the use of a smaller coil. In this case, the centre hole of the magnet placed on the coil, advantageously on top of the flow channel, can have a smaller diameter, approximately as small as 30 - 40 mm. Manufacturing costs of the magnet are generally the lower, the smaller the hole that needs to be produced in the magnet.

The device according to the invention can be realised using one coil or, in an example outside of the scope of the invention, with two coils. When one coil is used, the same coil both delivers and receives the frequency pulse. When two coils are used, one coil can deliver the frequency pulse and the other receives it. The use of one coil is possible, if the sample flows so slowly that the same protons that are exposed to the frequency pulse will also have time to deliver the response signal in the coil area. Alternatively, the device may include two valves, which are used to stop the sample for a moment at the coil and the magnet. In turn, the use of two coils enables the determination of the beating rate from a moving flow when correctly adjusted. The coil, also called bobbin, used in the device is electrically dimensioned in such a way that, with the selected power source, it can produce the desired frequency pulse, or excitation pulse, in the selected magnetic field. For example, when the strength of the magnetic field E is 0.5 T, the frequency pulse applied is in the frequency range of 25 - 26 MHz. Generally, the frequency pulse used is in the range of 50 kHz - 150 MHz. When one coil is used for the measurement, the length of the coil used may be approximately 10 - 20 cm, whereby protons in the fibre suspension flow will have time to get excited and deliver energy across the coil. The coil may have 100 - 200 turns.

Energy delivered by the proton p excited according to Figure 3 provides a response frequency in the coil 22, which can be measured as a response signal. The response signal to be measured can be measured with extremely sensitive measuring equipment 28, for example, with a receiver with its measuring accuracy in the class of 1 $\mu$V. The response signal to be measured is only an average signal, i.e. momentary values, based on which an average is calculated for a certain period, are measured for the response signal over this period. In other words, the entire spectrum is not measured, as is usually the case in spectroscopy. For example, the length of the period may be 0.5 - 2.0 s. Based on the strength of the response signal, the relaxation time T2 of the protons is calculated. The relaxation time can be calculated with the following formula:

$$T2 = -t/\{ln[a(t)/a_o\}$$

Advantageously, software means 30 can have been implemented in a computer 25, which can be used for presenting results as well as for controlling the device. The computer can be a normal PC or equivalent. The material of the flow channel is advantageously glass, Teflon or another equivalent nonmagnetic material, which does not disturb the generation of the magnetic field within the flow channel. In turn, the power source is an AC power source, in context with which a frequency converter can be used to achieve the correct frequency.

The control of device operations can take place with the same computer, provided with software means for determining the beating rate using an empirical formula based on measured relaxation times. To control the device, it is possible to use separate control software that provides electric controls via a field bus, for example, for valve actuators, which open the valve of the flow channel for taking the sample either periodically or continuously.

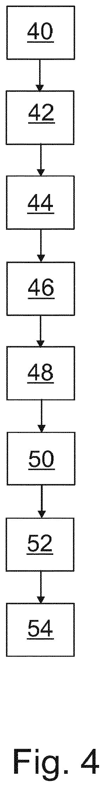

Figure 4 shows steps 42 - 54 of an embodiment of the method according to the invention in a block diagram. The method according to the invention starts from the taking of a sample, either after the beater 100 according to Figure 1a, or both before and after the beater 100 according to Figure 1b. Advantageously, the sample is taken, according to Figure 1b, both before the beater 100 and after the beater 100 by leading the fibre suspension to a separate side flow channel 102 as a sample, according to step 40, whereat the variation of the beating rate can be determined. Connected to the flow channel 101 leading to the beater 100 or exiting from the beater 100, there is a side flow channel 102 having a first valve 16 and a second valve 17. By opening the first valve 16, part of the fibre suspension is led to the side flow channel 102 as a sample either periodically or continuously. Advantageously, the flow is led to the side flow channel 102 periodically, since then the sample flow can be stopped within the magnet of the device 10 for the duration of the measurement by means of the first valve 16 and the second valve 17. Periodically repeated, sampling can be repeated at intervals of 1 - 2 minutes, for example.

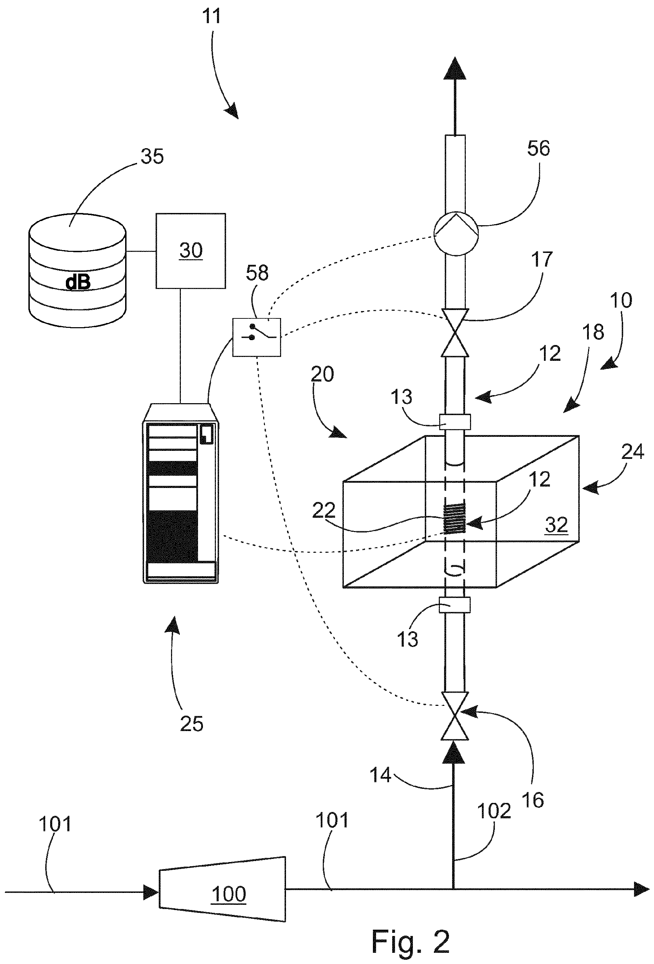

The first valve 16 and the second valve 17 are controlled preferably with a computer 25 and computer-operated software means 30, wherein the sampling interval or the necessary volumetric flow per period is defined. Based on the control software, the computer 25 sends a control command via a field bus, for example, advantageously to a relay 58 of Figure 2, via which the power supply is connected to the actuators of the first valve 16 and the second valve 17. Advantageously, the first valve 16 and the second valve 17 are solenoid valves, since solenoid valves are not as sensitive to environmental disturbances as other valve types. When the power supply to the actuators of the valves 16 and 17 is disconnected with the relay 58, the valves 16 and 17 will close, while when under voltage, the valves 16 ja 17 are in their open positions enabling the fibre suspension flow in the side flow channel 102.

Advantageously, the side flow channel 102 also includes a pump 56, with which a fibre suspension that is difficult to move can be reliably transferred along the side channel 102 to the equipment 18 for determining the beating rate. For example, the pump can be a hose pump. Advantageously, power is supplied to the pump 56 via the same relay 58 so that the entire sampling process can be managed by controlling one relay 58. The sample is aspirated to the side flow channel 102, until the sample is conveyed inside the magnet 24, whereat the power supply to the first valve 16 and the second valve 17 is disconnected with the relay 58, whereat these will close. At the same time, the power supply to the pump 56 is disconnected. The control of the relay 58 can be implemented by time control, for example.

At the same time, a magnetic field has been generated in the device using advantageously a permanent magnet applied as the magnet 24 in the device, according to step 42 of Figure 4. The purpose of the magnetic field is to enable excitation of protons with frequency pulses generated by the coil 22. When generated by a permanent magnet, the magnetic field is permanent and does not require any specific control. The computer can also be associated with an electronic control unit controlled by the control means, while the control unit, in turn, controls the power source of the device to generate frequency pulses for the coil, according to step 44 of Figure 4. Frequency pulses are advantageously generated at the frequency indicated above while the sample is in the magnetic field. Advantageously, the frequency pulse applied is the so-called CPMG frequency pulse, which includes one 90° pulse and several 180° pulses. Pulses are delivered one after the other and they excite the protons in the magnetic field, according to step 46 of Figure 4. The excitation is very rapidly discharged and the energy delivered by the proton arrives at the coil providing a low voltage in the coil, which is measured with the measuring equipment according to step 48. From the measuring equipment, the voltage data can be transferred in the analog form to an A/D converter or as a digital signal directly to the computer 25, where it will be stored in a memory 35 with the software means 30 for further processing.

The amplitude of the voltage is advantageously measured continuously and momentary measuring results of the voltage are stored in the memory. Advantageously, the sample in the magnetic field is exposed to four different frequency pulses generated with the coil, whereat four different attenuating signals are generated, the amplitudes of which are measured with the measuring equipment. Based on the amplitudes measured, an average can be calculated with the software means 30. In addition, an average can be calculated over successive samples, since variations between individual samples are notably greater than variations between the successive signals of the same sample.

The relaxation time T2 of the proton measured based on the measured amplitude of the response signal is used together with the empirically defined correlation function to determine the beating rate with software means 30 in step 50. Advantageously, the correlation function has been defined before the actual measurements when taking the device into use by measuring known relaxation times of fibre suspensions with different beating rates and by forming, based on these, a linear function between the relaxation times and the beating rate. Based on a determination, the formula Sr = - 277,8 * T2(NMR) + 334,9 was obtained for the correlation function. More generally, the correlation function has the form Sr = A * T2(NMR) + B, where Sr is the Schopper-Riegler number, T2(NMR) is the spin-spin relaxation time, A is a constant and B is a constant. In the actual measurement, the beating rate of the sample is determined by placing the defined relaxation time in the correlation function according to step 52 of Figure 4. The SR number can be presented as a time sequence and an averaging process, for example, can be performed to this (moving averaging), with which it is possible to eliminate differences between the samples pumped. Finally, the result of the beating rate determined can be transferred to the mill information system, for example. Finally, the sample can be led back to the fibre suspension flow according to step 54 of Figure 4.

In this context, it will be understood by those skilled in the art that the SR number is only one example of indices used for representing the beating rate. Other indices, such as the CSF number, can also be used in examples outside of the scope of the invention to represent the beating rate of a fibre suspension, after first empirically defining the correlation between the relaxation time and the CSF number experimentally.

A device according to the invention can be, excluding the sampling, control of sampling and calculation of the beating rate, a commercially available prior art time domain NMR spectroscope. One such useful spectroscope is the device known by the trade name "TD-NMR Analyzer Spin Track" manufactured by Resonance Systems Ltd.

The device and the method according to the invention can be used for measuring the beating rate of various fibre suspensions, such as pulp and paper suspensions, as an online process measurement, or, in an example outside of the scope of the invention, also as a laboratory measurement.

## Claims

1. A method for determining a beating rate of a fibre suspension, wherein part of a fibre suspension flow (14) is led to a separate flow channel (12) as a sample and the beating rate is determined based on the sample, **characterised in that** the beating rate is determined as an online measurement using a time domain NMR spectroscope (20) and an empirically defined correlation function having a form Sr = A * T2(NMR) + B, where Sr is the Schopper-Riegler number, T2 (NMR) is a spin-spin relaxation time and A and B are empirically determined constants, said method comprising the following steps:

   - generating a magnetic field (E) in said flow channel (12),
   - exciting protons (p) contained in water in the fibre suspension of the sample with several frequency pulses provided by a coil (22),
   - measuring response signals of the frequency pulses returning from protons (p) to the coil (22),
   - calculating the spin-spin relaxation time T2(NMR) of the protons based on amplitudes of the measured response signals,
   - determining the Schopper-Riegler number, Sr, as a representation of the beating rate of the fibre suspension using said correlation function based on the spin-spin relaxation time T2(NMR) calculated from the response signals.

2. A method according to Claim 1, **characterised in that** the correlation function is defined during an introduction into use of the NMR spectroscope (20) in steps, wherein NMR response signals are measured for several fibre suspensions with known Schopper-Riegler numbers, Sr, and a correlation function is formed between spin-spin relaxation times T2(NMR) calculated from the response signals and the Schopper-Riegler numbers, Sr.

3. A method according to claim 1 or 2, **characterised in that** the sample is taken from a fibre suspension flow (14) arriving from a beater (100).

4. A method according to any of Claims 1 to 3, **characterised in that** the sample is stopped in the flow channel (12) for the duration of generation of the frequency pulses and signal measurement.

5. A device (10) for determining beating rate of a fibre suspension as an online measurement, the device (10) being arranged to be connected to a side flow channel (102) arranged to lead part of a fibre suspension flow (14) arriving from a beater (100) to form a separate sample, the device (10) including

   - equipment (18) for determining a beating rate based on the sample, comprising a flow channel (12),

- connection means (13) configured for connecting said flow channel (12) to the side flow channel (102) to lead part of the fibre suspension flow (14) arriving from the beater (100) to the flow channel (12), **characterized in that** said equipment (18) for determining the beating rate further comprises a time domain NMR spectroscope (20), said NMR spectroscope (20) including:

- a coil (22) arranged around the flow channel (12) to excite protons (p) contained in water in the fibre suspension of the sample by means of frequency pulses,
- a magnet (24) arranged around said flow channel (12) configured for generating a magnetic field (E) in the flow channel (12),
- a power source (26) with controllers connected to the coil (22) configured for generating the frequency pulses,
- measuring equipment (28) configured for measuring the intensity of the voltage generated by the frequency pulses returning to the coil (22) from protons (p), for generating response signals, wherein said equipment (18) further comprises a computer (25) equipped with a software means (30) configured to calculate spin-spin relaxation time T2(NMR) of the protons based on amplitudes of the measured response signals and arranged to determine the Schopper-Riegler number, Sr, as a representation of the beating rate of the fibre suspension based on the spin-spin relaxation time T2(NMR) using an empirical correlation function having form $Sr = A * T2 (NMR) + B$, where A and B are empirically determined constants

6. A device according to Claim 5, **characterised in that** said magnet (24) is a permanent magnet.

7. A device according to Claim 5 or 6, **characterised in that** said magnet (24) and the coil (22) are overlapping in radial direction relative to the flow channel (12) in such a way that the flow channel (12) is surrounded by the coil (22) and the coil (22) is surrounded by the magnet (24).

8. A device according to any of Claims 5 to 7, **characterised in that** the device (10) includes a box construction (32) made of metal for encasing the magnet (24) and the coil (22) to prevent expansion of magnetic field (E) to environment and access of disturbances external to the device (10) to the magnetic field (E).

9. A system for determining the beating rate of a fibre suspension, including

- a side flow channel (102) arranged to be fastened in the vicinity of a beater (100) arranged to lead part of a fibre suspension flow (14) arriving from the beater (100) to form a separate sample,
- a device (10) combined with said side flow channel (102) being configured for determining the beating rate of the fibre suspension from the fibre suspension flow in the side flow channel (102), wherein said device (10) is a device (10) according to any of Claims 5 to 8.

10. A system according to Claim 9, **characterised in that** the system includes a first valve (16) arranged in said flow channel (12) before said equipment (18) and a second valve (17) arranged in the flow channel (12) after the equipment (18) for stopping the sample for duration of measurement performed by the equipment (18).

11. A system according to claim 10, **characterised in that** said first valve (16) and second valve (17) are solenoid valves.

12. A system according to any of Claims 9 to 11, **characterised in that** the system includes a pump (56) arranged in said flow channel (12) for aspirating the sample to said equipment (18).

13. A system according to any of Claims 9 to 12, **characterised in that** said pump (56) is a hose pump.

**Patentansprüche**

1. Verfahren zur Bestimmung einer Schlagzahl einer Fasersuspension, wobei ein Teil eines Fasersuspensionsstroms (14) als Probe in einen separaten Strömungskanal (12) geleitet wird und die Schlagzahl anhand der Probe bestimmt wird, **dadurch gekennzeichnet, dass** die Schlagzahl als Online-Messung unter Verwendung eines Zeitbereichs-NMR-Spektroskops (20) und einer empirisch definierten Korrelationsfunktion der Form $Sr = A * T2(NMR) + B$ bestimmt wird, wobei Sr die Schopper-Riegler-Zahl, T2(NMR) eine Spin-Spin-Relaxationszeit und A und B empirisch bestimmte Konstanten sind, das Verfahren umfassend die folgenden Schritte:

- Erzeugen eines Magnetfeldes (E) in dem Strömungskanal (12),
- Anregen von im Wasser in der Fasersuspension der Probe enthaltenen Protonen (p) mit mehreren Frequenzimpulsen, die von einer Spule bereitgestellt werden (22),

- Messen der Antwortsignale der Frequenzimpulse, die von den Protonen (p) zur Spule (22) zurückkehren,
- Berechnen der Spin-Spin-Relaxationszeit T2(NMR) der Protonen auf der Grundlage der Amplituden der gemessenen Antwortsignale,
- Bestimmen der Schopper-Riegler-Zahl Sr als einer Darstellung der Schlagzahl der Fasersuspension unter Verwendung der Korrelationsfunktion auf der Grundlage der aus den Antwortsignalen berechneten Spin-Spin-Relaxationszeit T2(NMR).

2. Verfahren nach Anspruch 1, **dadurch gekennzeichnet, dass** die Korrelationsfunktion während einer schrittweisen Inbetriebnahme des NMR-Spektroskops (20) definiert wird, wobei NMR-Antwortsignale für mehrere Fasersuspensionen mit bekannten Schopper-Riegler-Zahlen Sr gemessen werden und eine Korrelationsfunktion zwischen aus den Antwortsignalen berechneten Spin-Spin-Relaxationszeiten T2(NMR) und Schopper-Riegler-Zahlen Sr gebildet wird.

3. Verfahren nach Anspruch 1 oder 2, **dadurch gekennzeichnet, dass** die Probe aus einem Fasersuspensionsstrom (14) entnommen wird, der von einem Rührwerk (100) kommt.

4. Verfahren nach einem der Ansprüche 1 bis 3, **dadurch gekennzeichnet, dass** die Probe im Strömungskanal (12) für die Dauer der Erzeugung der Frequenzimpulse und der Signalmessung angehalten wird.

5. Vorrichtung (10) zur Bestimmung der Schlagzahl einer Fasersuspension als Online-Messung, wobei die Vorrichtung (10) eingerichtet ist, um mit einem seitlichen Strömungskanal (102) verbunden zu werden, der eingerichtet ist, um einen Teil eines von einem Rührwerk (100) kommenden Fasersuspensionsstroms (14) zur Bildung einer separaten Probe zu leiten, wobei die Vorrichtung (10) folgendes einschließt

- Einrichtung (18) zur Bestimmung einer Schlagzahl auf der Grundlage der Probe, umfassend einen Strömungskanal (12),
- Verbindungsmittel (13), konfiguriert zum Verbinden des Strömungskanals (12) mit dem seitlichen Strömungskanal (102), um einen Teil des vom Rührwerk (100) kommenden Fasersuspensionsstroms (14) in den Strömungskanal (12) zu leiten, **dadurch gekennzeichnet, dass** die Einrichtung (18) zum Bestimmen der Schlagzahl ferner ein Zeitbereichs-NMR-Spektroskop (20) umfasst, wobei das NMR-Spektroskop (20) Folgendes einschließt:

- eine Spule (22), die um den Strömungskanal (12) herum angeordnet ist, um Protonen (p), die im Wasser in der Fasersuspension der Probe enthalten sind, mit Frequenzimpulsen anzuregen,
- einen Magneten (24), der um den Strömungskanal (12) herum angeordnet und zum Erzeugen eines Magnetfeldes (E) in dem Strömungskanal (12) konfiguriert ist,
- eine Stromquelle (26) mit Steuerungen, die mit der Spule (22) verbunden und zum Erzeugen von Frequenzimpulsen konfiguriert ist,
- Messeinrichtung (28), die zum Messen der Intensität der Spannung konfiguriert ist, die von den zu der Spule (22) von den Protonen (p) zurückkehrenden Frequenzimpulsen erzeugt wird, um Antwortsignale zu erzeugen,

wobei die Einrichtung (18) ferner einen Computer (25) umfasst, der mit Softwaremitteln (30) ausgestattet ist, die konfiguriert sind, um die Spin-Spin-Relaxationszeit T2(NMR) der Protonen auf der Grundlage der Amplituden der gemessenen Antwortsignale zu berechnen, und die dazu vorgesehen sind, die Schopper-Riegler-Zahl, Sr, als eine Darstellung der Schlagzahl der Fasersuspension auf der Grundlage der Spin-Spin-Relaxationszeit T2(NMR) unter Verwendung einer empirischen Korrelationsfunktion der Form Sr = A * T2 (NMR) + B zu bestimmen, wobei A und B empirisch bestimmte Konstanten sind.

6. Vorrichtung nach Anspruch 5, **dadurch gekennzeichnet, dass** der Magnet (24) ein Dauermagnet ist.

7. Vorrichtung nach Anspruch 5 oder 6, **dadurch gekennzeichnet, dass** sich der Magnet (24) und die Spule (22) in radialer Richtung relativ zum Strömungskanal (12) so überlappen, dass der Strömungskanal (12) von der Spule (22) und die Spule (22) von dem Magneten (24) umgeben ist.

8. Vorrichtung nach einem der Ansprüche 5 bis 7, **dadurch gekennzeichnet, dass** die Vorrichtung (10) eine Kastenkonstruktion (32) aus Metall zum Umschließen des Magneten (24) und der Spule (22) einschließt, um eine Ausdehnung des Magnetfeldes (E) auf die Umgebung und den Zugang von außerhalb der Vorrichtung (10) auftretenden Störungen zum Magnetfeld (E) zu verhindern.

9. System zur Bestimmung der Schlagzahl einer Fasersuspension, wobei das System folgendes einschließt

- einen seitlichen Strömungskanal (102), der zur Befestigung in der Nähe eines Rührwerks (100) eingerichtet und dazu eingerichtet ist, einen Teil eines vom Rührwerk (100) kommenden Fasersuspensionsstroms (14) zu leiten, um eine separate Probe zu bilden,

- eine mit dem Strömungskanal (102) kombinierte Vorrichtung (10), die zur Bestimmung der Schlagrate der Fasersuspension aus dem durch den seitlichen Strömungskanal (102) fließenden Fasersuspensionsstrom konfiguriert ist, wobei die Vorrichtung (10) eine Vorrichtung (10) nach einem der Ansprüche 5 bis 8 ist.

10. System nach Anspruch 9, **dadurch gekennzeichnet, dass** das System ein in dem Strömungskanal (12) vor der Einrichtung (18) angeordnetes erstes Ventil (16) und ein in dem Strömungskanal (12) hinter der Einrichtung (18) angeordnetes zweites Ventil (17) einschließt, um die Probe für die Dauer der durch die Einrichtung (18) durchgeführten Messung anzuhalten.

11. System nach Anspruch 10, **dadurch gekennzeichnet, dass** das erste Ventil (16) und das zweite Ventil (17) Magnetventile sind.

12. System nach einem der Ansprüche 9 bis 11, **dadurch gekennzeichnet, dass** das System eine Pumpe (56) einschließt, die in dem Strömungskanal (12) zum Ansaugen der Probe zu der Einrichtung (18) angeordnet ist.

13. System nach einem der Ansprüche 9 bis 12, **dadurch gekennzeichnet, dass** die Pumpe (56) eine Schlauchpumpe ist.

**Revendications**

1. Procédé pour la détermination de la fréquence de battement d'une suspension de fibres, dans lequel une partie d'un flux de suspension de fibres (14) est dirigée vers un circuit distinct (12) en tant qu'échantillon et la fréquence de battement est déterminée à partir de l'échantillon, **caractérisé en ce que** la fréquence de battement est déterminée en tant que mesure en ligne à l'aide d'un spectroscope par RMN dans le domaine temporel (20) et de la fonction de corrélation définie de manière empirique Sr = A * T2(RMN) + B, où Sr est l'indice Schopper-Riegler, T2(RMN) est un temps de relaxation spin-spin, et A et B sont des constantes déterminées de manière empirique, ledit procédé comprenant les étapes suivantes:

- génération d'un champ magnétique (E) dans ledit circuit (12),
- excitation des protons (p) contenant de l'eau dans la suspension de fibres de l'échantillon avec plusieurs impulsions de fréquence envoyées par une bobine (22),
- mesure des signaux de réponse aux impulsions de fréquence revenant des protons (p) à la bobine (22),
- calcul du temps de relaxation spin-spin T2(RMN) des protons en fonction des amplitudes des signaux de réponse mesurés,
- détermination de l'indice Schopper-Riegler, Sr, en tant que représentation de la fréquence de battement de la suspension de fibres à l'aide de ladite fonction de corrélation selon le temps de relaxation spin-spin T2(RMN) calculé à partir des signaux de réponse.

2. Procédé conformément à la revendication 1, **caractérisé en ce que** la fonction de corrélation est définie au cours d'une mise en service du spectroscope par RMN (20) par étapes, où les signaux de réponse RMN sont mesurés pour plusieurs suspensions de fibres dont les indices Schopper-Riegler, Sr, sont connus et une fonction de corrélation est formée entre les temps de relaxation spin-spin T2(RMN) calculés à partir des signaux de réponse et des indices Schopper-Riegler, Sr.

3. Procédé conformément à la revendication 1 ou 2, **caractérisé en ce que** l'échantillon est extrait d'un flux de suspension de fibres (14) provenant d'un batteur (100).

4. Procédé conformément à l'une quelconque des revendications 1 à 3, **caractérisé en ce que** l'échantillon est arrêté dans le circuit (12) pendant la durée de génération des impulsions de fréquence et de mesure des signaux.

5. Dispositif (10) pour la détermination de la fréquence de battement d'une suspension de fibres en tant que mesure en ligne, le dispositif (10) étant disposé de façon à être raccordé à un circuit latéral (102) ayant pour fonction de dévier une partie d'un flux de suspension de fibres (14) provenant d'un batteur (100) pour former un échantillon distinct, le dispositif (10) comprenant

- un équipement (18) pour la détermination d'une fréquence de battement à partir de l'échantillon, comprenant un circuit (12),
- des moyens de raccordement (13) prévus pour raccorder ledit circuit (12) au circuit latéral (102) prévu pour dévier une partie du flux de suspension de fibres (14) arrivant dans le circuit (12) et provenant du batteur (100), **caractérisé en ce que** ledit équipement (18) pour la détermination de la fréquence de battement comprend également un spectroscope par RMN dans le domaine temporel (20), ledit spectroscope par RMN (20) comprenant:

- une bobine (22) disposée autour du circuit (12) pour exciter les protons (p) contenus dans l'eau dans la suspension de fibres de l'échantillon au moyen d'impulsions de fréquence,
- un aimant (24) disposé autour dudit circuit (12) prévu pour générer un champ magnétique (E) dans le circuit (12),
- une source d'alimentation (26) avec un système de commande connecté à la bobine (22) prévue pour générer les impulsions de fréquence,
- un équipement de mesure (28) prévu pour mesurer l'intensité de la tension générée par les impulsions de fréquence revenant des protons (p) à la bobine (22), pour générer des signaux de réponse,

ledit équipement (18) comprenant également un ordinateur (25) équipé d'un logiciel (30) configuré pour calculer le temps de relaxation spin-spin T2(RMN) des protons en fonction des amplitudes des signaux de réponse mesurés et prévu pour déterminer l'indice de Schopper-Riegler, Sr, en tant que représentation de la fréquence de battement de la suspension de fibres selon la durée de relaxation spin-spin T2(RMN) à l'aide de la fonction de corrélation empirique Sr = A * T2(RMN) + B, où A et B sont des constantes déterminées de manière empirique.

6. Dispositif conformément à la revendication 5, **caractérisé en ce que** ledit aimant (24) est un aimant permanent.

7. Dispositif conformément à la revendication 5 ou 6, **caractérisé en ce que** ledit aimant (24) et la bobine (22) sont superposés dans le sens radial par rapport au circuit (12) de sorte que le circuit (12) est entouré par la bobine (22) et la bobine (22) est entourée par l'aimant (24).

8. Dispositif conformément à l'une quelconque des revendications 5 à 7, **caractérisé en ce que** le dispositif (10) comprend une boîte (32) en métal destinée à contenir l'aimant (24) et la bobine (22) afin d'éviter que le champ magnétique (E) ne se propage à l'environnement et que des facteurs externes au dispositif (10) ne viennent perturber le champ magnétique (E).

9. Système pour la détermination de la fréquence de battement d'une suspension de fibres, comprenant

- un circuit latéral (102), fixé à proximité d'un batteur (100), prévu pour dévier une partie d'un flux de suspension de fibres (14) provenant du batteur (100) pour former un échantillon distinct,
- un dispositif (10) combiné audit circuit latéral (102) prévu pour déterminer la fréquence de battement de la suspension de fibres provenant du flux de suspension de fibres dans le circuit latéral (102), ledit dispositif (10) étant un dispositif (10) conformément à l'une quelconque des revendications 5 à 8.

10. Système conformément à la revendication 9, **caractérisé en ce que** le système comprend une première vanne (16) dans ledit circuit (12) en amont dudit équipement (18) et une deuxième vanne (17) dans le circuit (12) en aval de l'équipement (18) pour arrêter l'échantillon pendant la durée de la mesure effectuée par l'équipement (18).

11. Système conformément à la revendication 10, **caractérisé en ce que** lesdites première vanne (16) et deuxième vanne (17) sont des électrovannes.

12. Système conformément à l'une quelconque des revendications 9 à 11, **caractérisé en ce que** le système comprend une pompe (56) disposée dans ledit circuit (12) pour aspirer l'échantillon dans ledit équipement (18).

13. Système conformément à l'une quelconque des revendications 9 à 12, **caractérisé en ce que** ladite pompe (56) est une pompe à tuyau.

Fig. 1a

Fig. 1b

Fig. 2

Fig. 3

Fig. 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5302896 A
- JP 2005077135 A

**Non-patent literature cited in the description**

- **HELENA LENNHOLM et al.** The effects of laboratory beating on cellulose structure. *NORDIC PULP AND PAPER RESEARCH JOURNAL,* 01 May 1995, vol. 10 (2), ISSN 0283-2631, 104-109
- **TIE QIANG LI et al.** Water-cellulose interaction in wood pulp fiber suspensions studied by oxygen-17 and deuterium NMR relaxation. The effect of beating. *LANGMUIR,* 01 February 1992, vol. 8, ISSN 0743-7463, 680-686
- **MATS HAGGKVIST et al.** Effects of drying and pressing on the pore structure in the cellulose fibre wall studied by 1H and 2H NMR relaxation. *CELLULOSE,* 01 January 1998, vol. 5, ISSN 0969-0239, 33-49